(19) Europäisches Patentamt

European Patent Office

Office européen des brevets

(11) **EP 0 623 995 B1**

(12) **EUROPÄISCHE PATENTSCHRIFT**

(45) Veröffentlichungstag und Bekanntmachung des Hinweises auf die Patenterteilung:
**11.11.1998   Patentblatt 1998/46**

(51) Int Cl.⁶: **H03G 3/32**

(21) Anmeldenummer: **94105525.3**

(22) Anmeldetag: **09.04.1994**

(54) **Anordnung zur geräuschabhängigen Regelung der Lautstärke eines Autoradios**

Device for the noise dependent volume control of a car radio

Dispositif de réglage en fonction du bruit du volume d'un autoradio

(84) Benannte Vertragsstaaten:
**AT DE ES FR GB IT PT**

(30) Priorität: **03.05.1993   DE 4314451**

(43) Veröffentlichungstag der Anmeldung:
**09.11.1994   Patentblatt 1994/45**

(73) Patentinhaber: **Blaupunkt-Werke GmbH
D-31139 Hildesheim (DE)**

(72) Erfinder: **Höllermann, Jörg
D-31141 Hildesheim (DE)**

(56) Entgegenhaltungen:
**EP-A- 0 179 530        EP-A- 0 307 725
EP-A- 0 319 777        DE-A- 3 830 423**

**Beschreibung**

Die Erfindung betrifft eine Anordnung zur geräuschabhängigen Regelung der Lautstärke eines Autoradios, wobei mindestens ein Mikrofon im Fahrgastraum eines Kraftfahrzeugs angeordnet ist und aus den vom Mikrofon erzeugten Signalen eine Führungsgröße abgeleitet wird.

Um die Anpassung der Lautstärke eines Autoradios an den Geräuschpegel im Fahrgastraum eines Kraftfahrzeugs zu ermöglichen, sind verschiedene Verfahren und Anordnungen bekanntgeworden. In DE 37 30 763 wird eine Schaltung zur Geräuschkompensation beschrieben, bei welcher ein von einem Mikrofon im Fahrgastraum aufgenommenes Störsignal in verschiedenen Frequenzbereichen mit dem Nutzsignal verglichen wird. Die Vergleichsergebnisse werden wiederum getrennt für die jeweiligen Frequenzbereiche zur Regelung der Lautstärke verwendet. Zur Erzeugung einer Führungsgröße werden zwar dabei die vom Mikrofon zusätzlich zu den Störsignalen aufgenommenen Nutzsignale berücksichtigt, eine weitere Analyse der Störsignale findet jedoch nicht statt. Gleiches gilt für die Schaltung zur störgeräuschabhängigen Lautstärkeregelung wie sie in DE 37 41 253 beschrieben wird.

So werden bei der bekannten Schaltung zwar Störgeräuschanteile berücksichtigt, die es zu maskieren gilt. Diese werden beispielsweise durch folgendes verursacht: Abrollen der Räder auf wechselndem Fahrbahnbelag, Wind, Motor, Auspuffanlage, offenes Fenster bzw. Schiebedach, Ventilator und vieles andere mehr. Bei der bekannten Schaltung wird jedoch auch die Sprache zwischen den Kraftfahrzeuginsassen als Störgeräusch gewertet. Dieses führt dazu, daß beim Reden eines oder mehrerer der Kraftfahrzeuginsassen die Lautstärke heraufgesetzt wird. Daraufhin spricht der Kraftfahrzeuginsasse in der Regel lauter, um das Autoradio zu übertönen, dessen Lautstärke wieder entsprechend aufgeregelt wird. Im Extremfall muß der Kraftfahrzeuginsasse regelrecht gegen das Autoradio anschreien.

Es ist zwar bereits bekannt (DE 38 30 423 C2), Störgeräusche lediglich im Infraschallbereich (4Hz bis 12 Hz) auszuwerten. Da dieses Frequenzband unterhalb der Frequenzen der menschlichen Sprache liegt, entfällt somit das obengenannte Problem. Es liegen allerdings auch viele Störgeräusche oberhalb dieses Frequenzbereichs, beispielsweise Motordrehzahl, Windgeräusche und das Geräusch des Ventilators. Eine derartige Lautstärkeregelung reagiert daher unzureichend auf Störgeräusche.

Aus der EP-A-0179530 ist eine Schaltungsanordnung zur störgeräuschabhängigen Regelung der Lautstärke eines Autoradios bekannt, bei der in der Fahrgastzelle eines Kraftfahrzeugs ein Mikrofon angeordnet ist, wobei aus den mit dem Mikrofon aufgenommen Signalen eine Führungsgröße zur Regelung der Lautstärke des Autoradios abgeleitet wird. Dazu werden sukzessive aufgenommene Werte des Störsignals mit einem zuvor aufgenommenen und gespeicherten Wert des Störsignals verglichen und dann, wenn ein aufgenommener Wert des Störsignals innerhalb eine Toleranzbereichs um den gespeicherten Wert liegt, ein Zähler inkrementiert und der Vergleich mit einem weiteren Wert des Störsignals durchgeführt. Liegt dagegen der Wert des Störsignals außerhalb des Toleranzbereichs um den gespeicherten Wert, wird der Zähler zurückgesetzt, statt des gespeicherten Werts der aktuell aufgenommene Wert des Störsignals gespeichert, und der Ablauf mit dem Vergleich eines neuen Störsignalwerts mit dem nun aktuellen gespeicherten Wert fortgesetzt. Liegen während einer vorgegebenen Anzahl von Abtastschritten, also für eine vorgegebene Zeit die Werte des Störsignals im Toleranzbereich um den gespeicherten Wert, was sich darin äußert, daß der Zähler einen vorgegebenen Wert erreicht, so wird die Führungsgröße für die Lautstärkeregelung durch den gespeicherten Wert des Störsignals akutalisiert und der Zähler zurückgesetzt.

Das beschriebene Verfahren verhindert somit, daß sich der im aufgenommenen Störsignal enthaltene Sprachsignalanteil auf die Lautstärkeregelung auswirkt, dadurch, daß im Falle stark schwankender Störgeräuschpegel die Regelung ausgesetzt wird. Aufgabe der vorliegenden Erfindung ist es, eine Anordnung zur geräuschabhängigen Regelung der Lautstärke eines Autoradios anzugeben, die weitgehend alle auftretenden Störgeräusche berücksichtigt, auf Sprache jedoch möglichst nicht, oder nur in geringem Umfang anspricht.

Diese Aufgabe wird bei der erfindungsgemäßen Anordnung dadurch gelöst, daß Mittelwerte des Betrages der Störsignalamplituden über vorgegebene Zeiten gebildet werden, und daß die Führungsgröße für den Fall, daß der Mittelwert unterhalb der jeweils zuvor gebildeten Führungsgröße liegt, aus dem Mittelwert gebildet wird, und für den Fall, daß der Mittelwert nicht unterhalb der zuvor gebildeten Führungsgröße liegt, aus dem Wert der zuvor gebildeten Führungsgröße durch Erhöhung um eine zulässiges Maß gebildet wird.

Der erfindungsgemäßen Anordnung liegt die Erkenntnis zugrunde, daß einzelne Sprachimpulse stets von Pausen unterbrochen sind. So haben umfangreiche Versuche ergeben, daß die durchschnittliche Länge von Sprachimpulsen zwischen 50 ms und 200 ms, allenfalls maximal 800 ms beträgt und daß die Pausen im Bereich zwischen 20 ms und 40 ms liegen. Die angegebenen Bereiche ergeben sich aus individuellen Unterschieden von Sprecher zu Sprecher, aus dem Geschlecht des Sprechers und der jeweils gesprochenen Sprache, wie Deutsch, Englisch oder Französisch. Außerdem ergeben sich im wesentlichen innerhalb der obengenannten Grenze Unterschiede zwischen Monologen und Gesprächen mehrerer Teilnehmer.

Eine vorteilhafte Ausführungsform der Erfindung, bei der die vorgegebene Zeit für die Mittelwertbildung etwa 20 ms (= minimale Sprachpausenlänge) beträgt, hat sich durch Versuche bestätigt.

Durch die erfindungsgemäße vorgehensweise wird gewährleistet, daß alle anzutreffenden relevanten Fahrgeräuschanstiege (Beschleunigen, Fenster öffnen, Verschlechterung des Fahrbahnbelages usw.) hinreichend schnell bei der Bildung der Führungsgröße berücksichtigt werden. Ein Abnehmen der Fahrgeräuschpegel wird ohne Verzögerung sofort nachgeführt. Insbesondere wenn bei dieser Weiterbildung das zulässige Maß ein Faktor zwischen 1,01 und 1,03 ist, liegt der Anstieg der Lautstärke während typischer Sprachimpulse mit 50 ms bis 200 ms Länge unterhalb der Grenze des Lautstärkeunterscheidungsvermögens des menschlichen Gehörs.

Ein weiterer Vorteil der erfindungsgemäßen Anordnung besteht darin, daß kurze Störimpulse sich nicht nennenswert auf die Lautstärkeregelung auswirken, wie beispielsweise Türzuschlagen, Überfahren einzelner Schlaglöcher, kurzes Hupen, Berühren des Mikrofons.

Durch die in den weiteren Unteransprüchen aufgeführten Maßnahmen sind weitere vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1    ein Ausführungsbeispiel einer erfindungsgemäßen Anordnung,

Fig. 2    ein Flußdiagramm eines Programms zur Bildung der Führungsgröße und

Fig. 3    Spannungszeitdiagramme von bei der Anordnung nach Fig. 1 auftretenden Signalen.

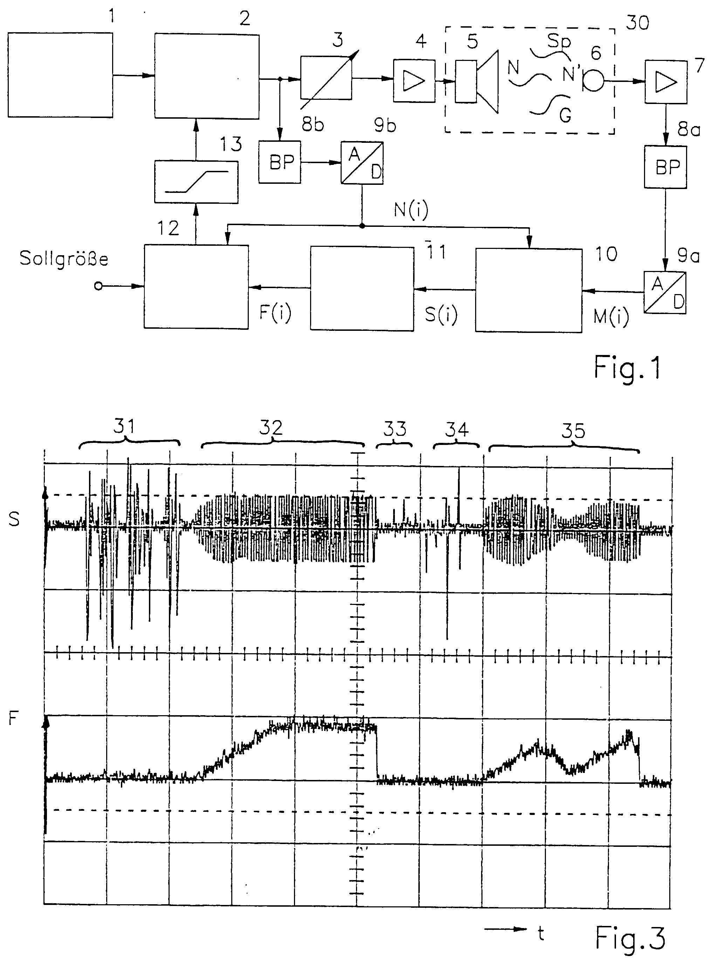

Bei dem Ausführungsbeispiel nach Fig. 1 sind nur diejenigen Teile des Autoradios schematisch dargestellt, die zum Verständnis der Erfindung erforderlich sind.

Die vom Benutzer aktivierte NF-Quelle 1 im Auto (Radioempfänger, Tonband, Cassette, DCC, DAT, CD, MD oder Autotelefon bei Integration ins Autoradiosystem) gibt das NF-Signal über ein automatisch geregeltes NF-Stellglied 2 an den manuellen Lautstärkesteller 3. Nach Verstärkung in einer Endstufe 4 wird das NF-Signal einem Lautsprecher 5 zugeführt, der das akustische Nutzsignal N in den Fahrgastraum 30 eines Kraftfahrzeugs abstrahlt.

Das NF-Stellglied 2 beinhaltet in an sich bekannter Weise Schaltungen (Equalizer) zur Steuerung des Pegels der NF-Signale innerhalb verschiedener Frequenzbereiche. Ein im Fahrgastraum angeordnetes Mikrofon 6 nimmt das vom Lautsprecher 5 abgestrahlte und durch Dämpfung und Reflexionen im Fahrgastraum beeinflußte Nutzsignal N', ein Geräuschsignal G und Sprache Sp der Fahrzeuginsassen auf. An das Mikrofon 6 ist nach einem Verstärker 7 und einem Bandpaß 8a ein Analog/Digital-Wandler 9a angeschlossen, welcher digitale Signale $M(i) = N'(i)+Sp(i)+G(i)$ einer Schaltungsanordnung 10 zuführt.

Die Schaltungsanordnung 10 dient zur Elimination des akustischen Nutzsignals $N'(i)$ aus dem Mikrofonsignal $M(i)$. Dazu wird das elektrische Nutzsignal $N(i)$ genau wie das Mikrofonsignal über einen Bandpaß 8b und einen Analog/Digital-Wandler 9b ebenfalls der Schaltungsanordnung 10 zugeführt. $N(i)$ wird dann durch ein im einzelnen nicht dargestelltes Adaptivfilter so bearbeitet, daß es dem akustischen Nutzsignal $N'(i)$ entspricht, und von $M(i)$ anschließend subtrahiert. Dazu muß das Adaptivfilter die akustische zeitvariante Übertragungsfunktion des Autoinnenraums nachbilden, was durch Adaption mittels LMS-Algorithmus mit folgender Grundgleichung realisiert wird: $M(i)-N(i)*$Adaptionsfilter sei so klein wie möglich. Die genaue Anwendung des LMS-Algorithmus für diesen Einsatz wird in DE 37 41 253 beschrieben. Die Adaptivfilter mit ihrem LMS-Algorithmus sind doppelt ausgeführt, um die in dem Mikrofonsignal $M(i)$ enthaltene überlagerte Stereoinformation $N'(i)$ durch die im elektrischen Nutzsignal $N(i)$ unabhängig voneinander vorliegenden rechten und linken Anteile getrennt herauszufiltern.

Als Ergebnis, das dem verbleibenden Schätzfehler nach Adaptivfilterung über den LMS-Algorithmus entspricht, liegt am Ausgang der Schaltungsanordnung 10 das Signal $S(i) = M(i)-N'(i) = Sp(i)+G(i)$ vor. Es enthält demnach nur noch die durch den Fahrbetrieb erzeugten Geräusche $G(i)$ und die Sprache $Sp(i)$ im Innenraum, deren Einfluß es im nachfolgenden Schaltungsteil 11 zu eliminieren gilt.

Dort wird - wie im folgenden noch näher beschrieben - aus dem Eingangssignal $S(i)$ eine Führungsgröße $F(i)$ abgeleitet, die nur noch von $G(i)$ abhängt, in der also der Spracheinfluß eliminiert wurde.

Die Führungsgröße $F(i)$ schließlich wird einem Regler 12 zugeführt. In diesem werden sowohl $F(i)$ als auch $N(i)$ getrennt voneinander über einen Spitzenwertdemodulator (VZ1-Glied) und eine Linear/Logarithmus-Umrechnung geleitet, bevor sie voneinander subtrahiert werden. Das Ergebnis stellt dar, um wieviel der Spitzenwert des Nutzsignals zur Zeit über oder unter dem Spitzenwert des Fahrgeräusches liegt. Dazu wird ein vom Benutzer einstellbarer gewünschter Wert addiert (Sollgröße Lautstärkeabhebung in dB) und dieses Ergebnis über ein Integrationsglied im Regler 12 (zur Stabilisierung des Regelverhaltens) und einen Begrenzer 13 als Stellgröße auf die entsprechenden Frequenzbänder des NF-Stellgliedes 2 (Equalizer) geleitet. Das Grundverfahren dieses Reglers wird in DE 37 30 763 beschrieben.

Die Begrenzerschaltung 13 erfüllt dabei folgende Funktionen: der minimale Wert der Pegelanhebung (Stellgröße) in allen Frequenzbändern wird auf Null begrenzt, so daß das Nutzsignal auch bei sehr leisem Fahrgeräusch oder bei stehendem Auto immer mit der Grundlautstärke wiedergegeben wird, die der Benutzer über den manuellen Lautstärkesteller 3 des Autoradios eingestellt hat. Der maximale Wert der Pegelanhebung wird auf 30 dB oberhalb dieser Grundlautstärke begrenzt, um zu verhindern, daß der Nutzsignalpegel bei sehr hohen Fahrgeräuschpegeln allein durch die Regelung von Benutzer ungewollt einen Wert erreichen kann, der auf Dauer das Gehör schädigen würde.

Damit ist der Regelkreis geschlossen. Die primäre Regelgleichung lautet: Pegel von F(i) minus Pegel von N(i) plus Soll-Lautstärkeabhebung sei gleich 0 dB. Daraus ergibt sich der aktuelle Lautstärkepegel von N als Summe von Fahrgeräuschpegel plus gewünschter Pegelabhebung zur Vermeidung der akustischen Maskierung des Nutzsignals durch das Fahrgeräusch.

Zur Vereinfachung des Schaltbildes wurde in Fig. 1 nicht eingezeichnet, daß N(i) und S(i) jeweils in eine Reihe von Frequenzbereichen unterteilt werden. Die Schaltungsteile 11 bis 13 sind für jeden dieser Frequenzbereiche getrennt ausgeführt, da sich das Störverhalten eines Autos im Fahrbetrieb in unterschiedlichen Frequenzbereichen anders verhält (vgl. DE 37 30 763 und DE 37 41 253) und man nur diejenigen Frequenzbereiche mittels Equalizer 2 anheben möchte, die sonst tatsächlich akustisch verdeckt würden. Die Schaltungsanordnungen 10 bis 13 bestehen in vorteilhafter Weise aus einem digitalen Signalprozessor.

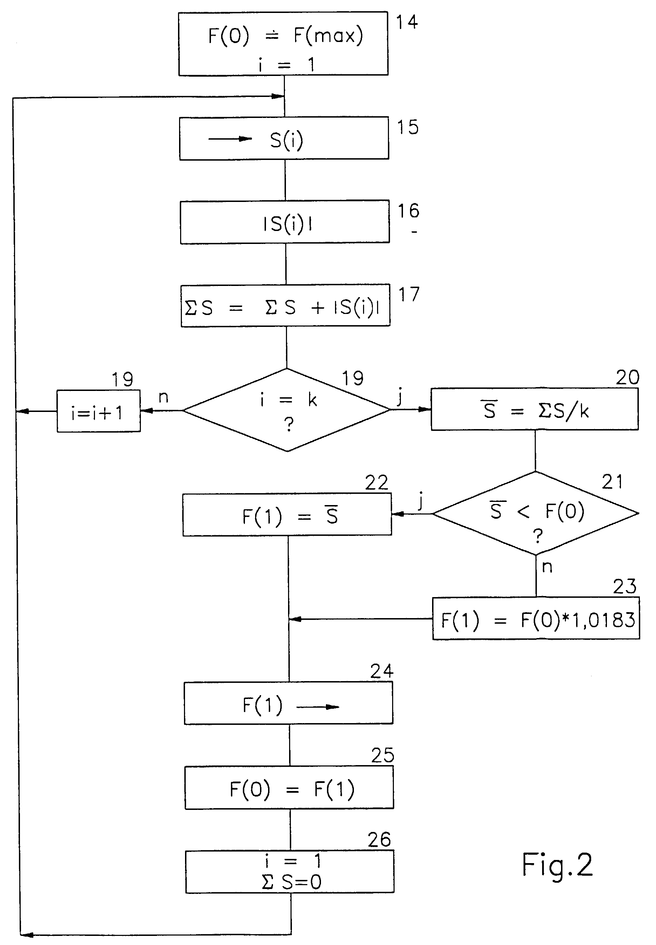

Fig. 2 zeigt in Form eines Flußdiagramms die Signalverarbeitung, die in der Schaltungsanordnung 11 zur Bildung der Führungsgröße F führt. Nach einer Initialisierung des Programms bei 14, bei der das Signal F(0) auf die größte darstellbare Zahl und ein Zähler i auf 1 gesetzt wird, wird bei 15 ein Abtastwert des Signals S(i) vom Ausgang des Adaptivfilters 10 übernommen. Bei 16 wird der Betrag dieses Abtastwertes gebildet, worauf bei 17 der Betrag des Abtastwertes zu der bisherigen Summe der Beträge der Abtastwerte hinzuaddiert wird.

Danach wird das Programm bei 18 in Abhängigkeit davon weitergeführt, ob der Zähler i den Wert k erreicht hat. k ist ein Vielfaches der Periode, mit welcher jeweils ein neuer Wert S(i) eingelesen wird, wodurch sich die Zeit der Mittelwertbildung ergibt - im dargestellten Ausführungsbeispiel 20 ms. Solange i noch nicht den Wert k erreicht hat, wird i bei 19 inkrementiert und bei 15 ein neuer Abtastwert S(i) eingelesen. Hat jedoch i den Wert k erreicht, so wird bei 20 der Mittelwert $\bar{S} = \Sigma S/k$ gebildet. Eine anschließende Verzweigung 21 ist davon abhängig, ob $\bar{S} \leq F(0)$ ist. Ist dieses der Fall, was in der Regel einer Sprachpause entspricht, wird bei 22 der Wert F(1) der Führungsgröße gleich $\bar{S}$ gesetzt.

Ist $\bar{S}$ nicht kleiner als F(0), so wird die Führungsgröße um einen Anstiegsfaktor dadurch erhöht, daß bei 23 F(1) = F(0)·1,0183 gesetzt wird. Bei 24 wird F(1) dann an den Regler 11 (Fig. 1) ausgegeben und bei 25 der neue Wert F(1) der Führungsgröße als F(0) abgelegt. Im Programmteil 26 wird dann i wieder auf 1 gesetzt, worauf im Programmteil 15 wieder ein Abtastwert eingelesen wird.

Fig. 3 zeigt im oberen Teil ein Oszillogramm der durch das Mikrofon aufgenommenen Signale S und im unteren Teil den zeitlichen Verlauf der daraus abgeleiteten Führungsgröße F. Der Zeitmaßstab beträgt 5 s/Teilung. In einem ersten Zeitabschnitt 31 wird bei stehendem Fahrzeug ein Satz gesprochen. Daraufhin erfolgt in einem Zeitabschnitt 32 eine Beschleunigung des Fahrzeugs und anschließend eine Fahrt mit konstanter Geschwindigkeit. In den Zeitabschnitten 33 und 34 werden bei stehendem Fahrzeug Händeklatschen und Türzuschlagen aufgenommen. Im Zeitabschnitt 35 erfolgt ein Wechsel zwischen Beschleunigung und Bremsen.

Die Führungsgröße F behält während der Zeitabschnitte 31, 33 und 34 den Wert 0 bei, da Sprache und kurze Geräusche, wie Händeklatschen und Türzuschlagen, sich nicht auf die Ableitung der Führungsgröße auswirken. Die Lautstärke wird also während dieser Zeitabschnitte gegenüber der eingestellten Lautstärke nicht erhöht. Der aus Fig. 3 ersichtliche langsamere Anstieg der Führungsgröße gegenüber dem Anstieg der Störgeräusche beim Fahren hat sich bei praktischen Versuchen nicht als nachteilig ergeben.

**Patentansprüche**

1. Anordnung zur geräuschabhängigen Regelung der Lautstärke eines Autoradios, wobei mindestens ein Mikrofon (6) im Fahrgastraum (30) eines Kraftfahrzeugs angeordnet ist und aus den vom Mikrofon (6) erzeugten Signalen (M(i)) eine Führungsgröße (F(i)) abgeleitet wird, dadurch gekennzeichnet, daß Mittelwerte ($\bar{S}$) des Betrages der Störsignalamplituden (S(i)) über vorgegebene Zeiten gebildet werden, und daß die Führungsgröße (F(i)) dann, wenn der Mittelwert ($\bar{S}$) unterhalb der jeweils zuvor gebildeten Führungsgröße liegt, aus dem Mittelwert ($\bar{S}$) gebildet wird, und während Zeitabschnitten, in denen der Mittelwert ($\bar{S}$) nicht unterhalb der zuvor gebildeten Führungsgröße liegt, um ein zulässiges Maß erhöht wird.

2. Anordnung nach Anspruch 1, dadurch gekennzeichnet, daß die vorgegebene Zeit etwa 20 ms beträgt.

3. Anordnung nach einem der vorhergehenden Ansprüche, dadurch gekennzeichnet, daß das zulässige Maß ein Faktor zwischen 1,01 und 1,03 ist.

4. Anordnung nach einem der vorhergehenden Ansprüche, dadurch gekennzeichnet, daß dem Mikrofon (6) ein Bandpaß (8a) mit einem Durchlaßbereich von etwa 120 Hz bis 3 kHz nachgeschaltet ist.

5. Anordnung nach einem der vorhergehenden Sprüche, dadurch gekennzeichnet, daß die Signale in digitale Signale umgewandelt werden, und daß die Führungsgröße (F(i)) mit Hilfe eines digitalen Signalprozessors abgeleitet wird.

**6.** Anordnung nach einem der vorgehenden Ansprüche, dadurch gekennzeichnet, daß eine von der Führungsgröße (F(i)) abgeleitete Stellgröße auf Werte zwischen einem Minimalwert und einem Maximalwert begrenzt wird, wobei der Minimalwert eine, vorzugsweise einstellbare, Grundlautstärkeeinstellung bewirkt, die auch ohne vom Mikrofon (6) aufgenommene Geräusche vorliegt, und der Maximalwert eine gehörschädigende Lautstärke verhindert.

**7.** Anordnung nach einem der vorgehenden Ansprüche, dadurch gekennzeichnet, daß die Mittelwertbildung und die Ableitung der Führungsgröße sowie eine anschließende Regelung getrennt für verschiedene Frequenzbereiche vorgenommen wird.

**Claims**

**1.** Arrangement for controlling the volume of a car radio as a function of the vehicle noise level, at least one microphone (6) being arranged in the passenger compartment (30) of a motor vehicle and a reference variable (F(i)) being derived from the signals (M(i)) produced by the microphone (6), characterized in that the mean values ($\bar{s}$) of the magnitude of the noise signal amplitudes (S(i)) are formed of over predetermined times, and in that the reference variable (F(i)) is formed from the mean value ($\bar{s}$) whenever the mean value ($\bar{s}$) lies below the reference variable respectively formed beforehand, and is increased by an allowed degree during time intervals in which the mean value ($\bar{s}$) does not lie below the reference variable formed beforehand.

**2.** Arrangement according to Claim 1, characterized in that the predetermined time is about 20 ms.

**3.** Arrangement according to one of the preceding claims, characterized in that the allowed degree is a factor between 1.01 and 1.03.

**4.** Arrangement according to one of the preceding claims, characterized in that a bandpass filter (8a) having a passband of about 120 Hz to 3 kHz is connected downstream of the microphone (6).

**5.** Arrangement according to one of the preceding claims, characterized in that the signals are converted into digital signals, and in that the reference variable (F(i)) is derived with the aid of a digital signal processor.

**6.** Arrangement according to one of the preceding claims, characterized in that a control variable derived from the reference variable (F(i)) is restricted to values between a minimum value and a maximum value, the minimum value bringing about a preferably adjustable basic volume setting which exists even if the microphone (6) does not receive any noise, and the maximum value being used to prevent a volume which causes auditory damage.

**7.** Arrangement according to one of the preceding claims, characterized in that the averaging and the derivation of the reference variable, as well as a subsequent control procedure, are carried out separately for different frequency ranges.

**Revendications**

**1.** Dispositif pour réguler le volume sonore d'un autoradio en fonction du bruit, comportant :

- un micro (6) placé dans l'habitacle (30) d'un véhicule automobile et, à partir des signaux (M(i)) générés par le micro (6), on déduit une grandeur guide (F(i)),

caractérisé en ce que
la valeur moyenne ($\bar{s}$) de l'amplitude du signal parasite (S(i)) est formée sur une durée prédéterminée, et la grandeur guide (F(i)) est formée à partir de la valeur moyenne ($\bar{s}$) si cette valeur moyenne ($\bar{s}$) est inférieure à la grandeur guide formée chaque fois précédemment et, pendant les intervalles de temps dans lesquels la valeur moyenne ($\bar{S}$) n'est pas inférieure à la grandeur guide formée précédemment, on augmente d'une valeur autorisée.

**2.** Dispositif selon la revendication 1,
caractérisé en ce que
le temps prédéterminé est d'environ 20 ms.

**3.** Dispositif selon l'une des revendications précédentes,
caractérisé en ce que
la valeur autorisée est un facteur compris entre 1,01 et 1,03.

**4.** Dispositif selon l'une des revendications précédentes,
caractérisé en ce que
le micro (6) est suivi d'un filtre passe-bande (8a) ayant une plage passante comprise entre 120 Hz et 3 kHz.

**5.** Dispositif selon l'une quelconque des revendications précédentes,
caractérisé en ce que
les signaux sont convertis en des signaux numériques et la grandeur guide (F(i)) est déduite à l'aide d'un processeur numérique de signaux.

6. Dispositif selon l'une quelconque des revendications précédentes,
   caractérisé en ce qu'
   une grandeur de réglage déduite de la grandeur guide (F(i)) est limitée à des valeurs comprises entre une valeur maximale et une valeur minimale, la valeur minimale assurant un réglage de l'intensité sonore de base, de préférence réglable, qui s'applique également au bruit reçu sans le micro (6), et la valeur maximale évitant une intensité sonore dangereuse pour les oreilles.

7. Dispositif selon l'une quelconque des revendications précédentes,
   caractérisé en ce que
   la formation de la valeur moyenne et la déduction de la grandeur guide, ainsi qu'une régulation consécutive, sont des opérations effectuées séparément pour les différentes plages de fréquences.

Fig.1

Fig.3

Fig.2